(19) Europäisches Patentamt
European Patent Office
Office européen des brevets

(11) **EP 2 873 955 A2**

(12) **EUROPEAN PATENT APPLICATION**

(43) Date of publication:
**20.05.2015 Bulletin 2015/21**

(51) Int Cl.:
**G01J 5/02** (2006.01)　　　　**G01J 5/10** (2006.01)
**H01L 27/146** (2006.01)

(21) Application number: **14192439.9**

(22) Date of filing: **10.11.2014**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **15.11.2013 JP 2013237277**

(71) Applicant: **Kabushiki Kaisha Toshiba**
**Tokyo 105-8001 (JP)**

(72) Inventors:
• **Ishii, Koichi**
**Tokyo, 105-8001 (JP)**
• **Funaki, Hideyuki**
**Tokyo, 105-8001 (JP)**

(74) Representative: **Hoffmann Eitle**
**Patent- und Rechtsanwälte PartmbB**
**Arabellastraße 30**
**81925 München (DE)**

(54) **Infrared imaging element, imaging device, and imaging system**

(57)　　An infrared imaging element (10) of an embodiment includes: a first pixel portion (11) including a first cell portion (20) including a first infrared ray detecting portion detecting a first infrared ray and a second infrared ray with a wavelength different from a wavelength of the first infrared ray, and first supporting legs (21a, 21b) that support the first cell portion, the first supporting legs including a first and second wiring lines (22a, 22b) that convey an electrical signals obtained by the first infrared ray detecting portion; and a second pixel portion (12) including a second cell portion (30) including a second infrared ray detecting portion detecting the second infrared ray, and second supporting legs (31a,31b) that support the second cell portion, the second supporting legs including a third and fourth wiring lines (32a,32b) that convey an electrical signal obtained by the second infrared ray detecting portion.

A-A SECTION

**FIG. 2A**

Description

FIELD

Embodiments described herein relate generally to infrared imaging elements, imaging devices, and imaging systems.

BACKGROUND

Infrared imaging elements utilizing infrared rays are passive sensors capable of detecting the temperature distribution of objects without requiring light sources. Infrared rays pass through smoke and fog more easily than visible light rays, and infrared imaging elements may capture images during both daytime and nighttime.

On the other hand, multiple wavelength sensors capable of detecting multiple wavelengths of images at a time are being developed. Since it is possible to determine the emissivity of an object by obtaining images thereof in a plurality of wavelengths, the material and the absolute temperature of the object can be detected by using a multiple wavelength sensor. The multiple wavelength sensors may be applied to such purposes as thermography, remote sensing, or gas detection.

Multiple wavelength sensors capable of simultaneously detecting a plurality of wavelengths as described above are quantum type infrared sensors utilizing electron transition between band gaps caused by incident infrared rays. The quantum type infrared sensors should operate at low temperatures in order to prevent thermal excitation. For this reason, the quantum type infrared sensors need a cooling mechanism, which increases the costs as the size of the sensors increases.

Another method is to utilize a plurality of lenses each transmitting light of a different wavelength band to obtain images with multiple wavelengths. This method, however, requires a lens-switching mechanism, which also makes it difficult to control the size of the device and the costs.

BRIEF DESCRIPTION OF THE DRAWINGS

Fig. 1 is a plan view of an infrared imaging element according to a first embodiment.

Fig. 2A is a cross-sectional view of a first pixel portion of the first embodiment taken along line A-A of Fig. 1.

Fig. 2B is a cross-sectional view of the first pixel portion of the first embodiment taken along line A'-A' of Fig. 1.

Fig. 3A is a cross-sectional view of a second pixel portion of the first embodiment taken along line B-B of Fig. 1.

Fig. 3B is a cross-sectional view of the second pixel portion of the first embodiment taken along line B'-B' of Fig. 1.

Fig. 4 is a diagram for explaining the function of the first pixel portion of the first embodiment.

Fig. 5 is a diagram for explaining the function of the second pixel portion of the first embodiment.

Fig. 6 is a diagram for explaining the function of the first and the second pixel portions of the first embodiment.

Fig. 7 is a cross-sectional view showing a method of manufacturing the infrared imaging element according to the first embodiment.

Fig. 8 is a cross-sectional view showing the method of manufacturing the infrared imaging element according to the first embodiment.

Fig. 9 is a cross-sectional view showing the method of manufacturing the infrared imaging element according to the first embodiment.

Fig. 10 is a cross-sectional view showing the method of manufacturing the infrared imaging element according to the first embodiment.

Fig. 11 is a cross-sectional view showing the method of manufacturing the infrared imaging element according to the first embodiment.

Fig. 12 is a cross-sectional view showing the method of manufacturing the infrared imaging element according to the first embodiment.

Fig. 13 is a cross-sectional view showing the method of manufacturing the infrared imaging element according to the first embodiment.

Fig. 14 is a cross-sectional view showing the method of manufacturing the infrared imaging element according to the first embodiment.

Fig. 15 is a cross-sectional view showing the method of manufacturing the infrared imaging element according to the first embodiment.

Fig. 16 is a cross-sectional view showing the method of manufacturing the infrared imaging element according to the first embodiment.

Fig. 17 is a cross-sectional view showing the method of manufacturing the infrared imaging element according to the first embodiment.

Fig. 18 is a cross-sectional view showing a first pixel portion of a second embodiment.

Fig. 19 is a cross-sectional view showing a second pixel portion of the second embodiment.

Fig. 20 is a cross-sectional view showing a first pixel portion of a modification of the second embodiment.

Fig. 21 is a cross-sectional view showing a second pixel portion of the modification of the second embodiment.

Fig. 22 is a block diagram showing an imaging system according to a third embodiment.

Fig. 23 is a diagram showing relative intensity spectra of gasoline flame, a high-temperature object, and a low-temperature object.

DETAILED DESCRIPTION

An infrared imaging element according to an embodiment includes: a substrate having a surface in which a first recess and a second recess are provided; a first pixel portion including a first cell portion disposed above the first recess and including a first infrared ray detecting portion that detects a first infrared ray with a wavelength incident from outside and a second infrared ray with a wavelength different from the wavelength of the first infrared ray and converts the first and the second infrared rays to electrical signals, and first supporting legs that support the first cell portion to be above the first recess, the first supporting legs including a first wiring line and a second wiring line that convey the electrical signals obtained by the first infrared ray detecting portion; and a second pixel portion including a second cell portion disposed above the second recess and a second infrared ray detecting portion that detects the second infrared ray and converts the detected second infrared ray to an electrical signal, and second supporting legs that support the second cell portion to be above the second recess, the second supporting legs including a third wiring line and a fourth wiring line that convey the electrical signal obtained by the second infrared ray detecting portion.

Embodiments will now be explained with reference to the accompanying drawings.

(First Embodiment)

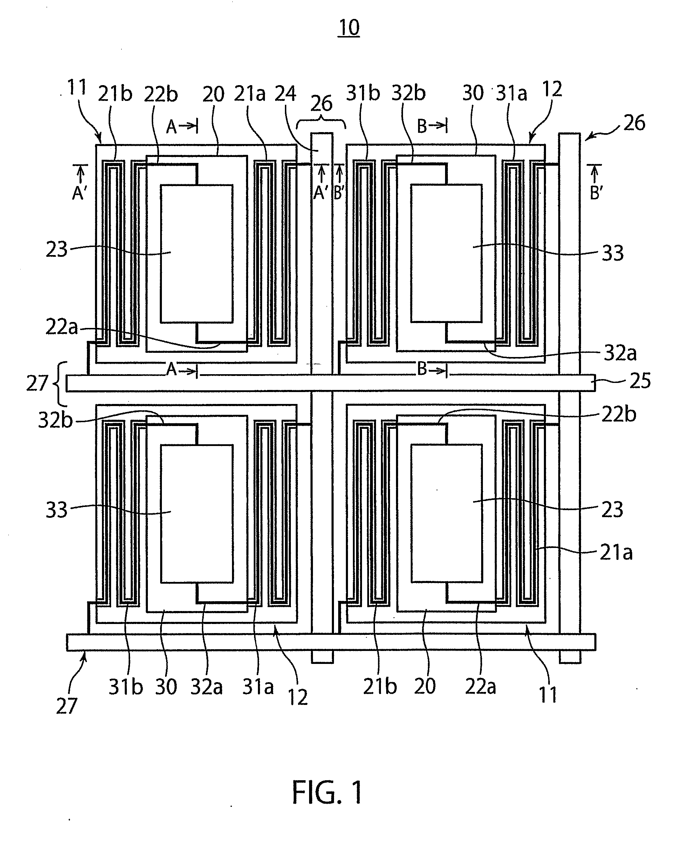

Fig. 1 is an infrared imaging element according to a first embodiment. Fig. 1 is a plan view showing the infrared imaging element 10 of the first embodiment. The infrared imaging element 10 of the first embodiment includes first and second pixel portions 11, 12 arranged in a matrix form having rows and columns, first wiring portions 26 each corresponding to one of the columns and extending along the corresponding column, and second wiring portions 27 each corresponding to one of the rows and extending along the corresponding row.

The first pixel portions 11 and the second pixel portions 12 are alternately arranged in the row direction and the column direction. Each first wiring portion 26 is disposed between a first pixel portion 11 and a second pixel portion 12 adjacent to each other in the row direction. Each second wiring portion 27 is disposed between a first pixel portion 11 and a second pixel portion 12 adjacent to each other in the column direction.

Each first pixel portion 11 includes a first cell portion 20 and first supporting legs 21a, 21b supporting the first cell portion 20. The first supporting legs 21a, 21b include first pixel wiring lines 22a, 22b, respectively. The first cell portion 20 includes a first thermoelectric converter 23. One terminal of the first thermoelectric converter 23 is connected to the first wiring portion 26 of the corresponding column via the first pixel wiring line 22a, and the other terminal is connected to the second wiring portion 27 of the corresponding row via the first pixel wiring line 22b.

The second pixel portion 12 includes a second cell portion 30 and second supporting legs 31a, 31b supporting the second cell portion 30. The second supporting legs 31a, 31b include second pixel wiring lines 32a, 32b, respectively. The second cell portion 30 includes a second thermoelectric converter 33. One terminal of the second thermoelectric converter 33 is connected to the first wiring portion 26 of the corresponding column via the second pixel wiring line 32a, and the other end is connected to the second wiring portion 27 via the second pixel wiring line 32b.

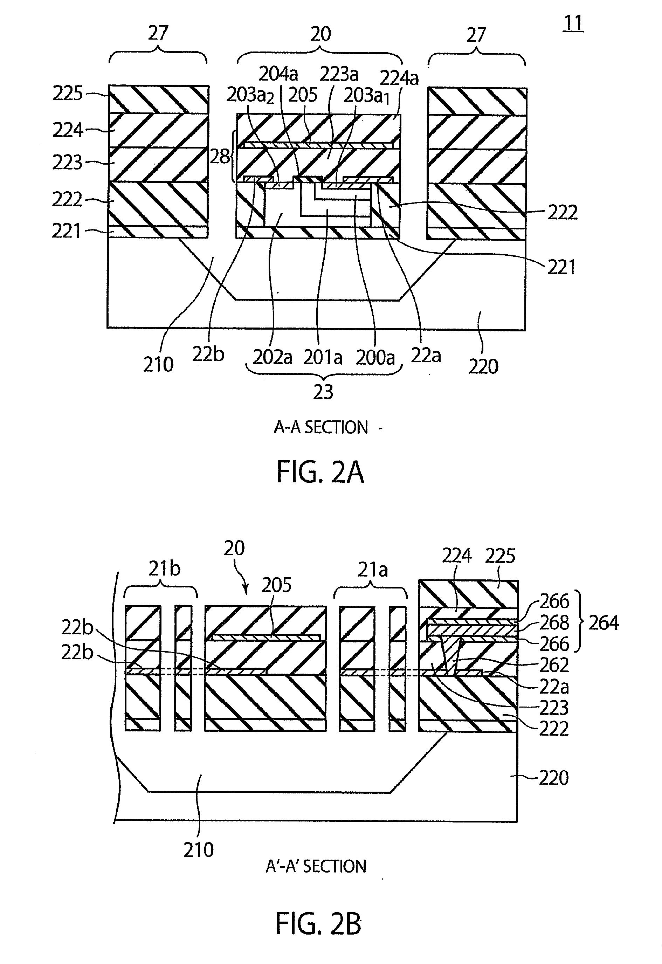

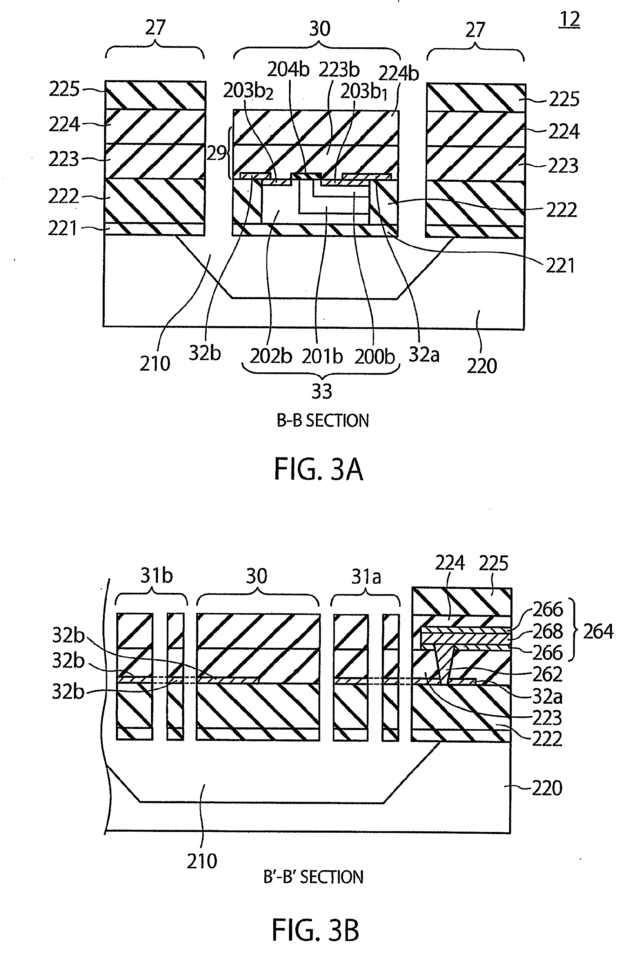

Detailed structures of the first pixel portion 11 and the second pixel portion 12 will be described with reference to Figs. 2A to 3B. Figs. 2A and 2B are cross-sectional views of the first pixel portion 11 of the infrared imaging element 10 according to the first embodiment taken along lines A-A and A'-A' in Fig. 1. Figs. 3A and 3B are cross-sectional views of the second pixel portion 12 of the infrared imaging element 10 according to the first embodiment taken along lines B-B and B'-B' in Fig. 1.

The first cell portion 20 is supported by the first supporting legs 21a, 21b above a recess 210 formed in a support substrate 220 of an SOI substrate including the support substrate 220, an insulating film 221, and a silicon on insulator (SOI) layer (Figs. 1, 2A, and 2B). The second wiring portions 27 are formed on regions of the substrate 220 where no recess 210 is formed (Figs. 2A and 2B).

The first cell portion 20 includes a first infrared ray absorbing portion 28 for absorbing infrared rays from the outside, and a first thermoelectric converter 23 for converting heat generated by the infrared ray absorption to electrical signals. The first infrared ray absorbing portion 28 includes a conductive layer 205, a protective film 224a for protecting the conductive layer 205, and an infrared ray absorbing layer 223a.

The first thermoelectric converter 23 is formed in the SOI layer of the SOI substrate, and includes an $n^+$ region 200a, a p-region 201a, and a $p^+$ region 202a to form a pn junction diode. The pn junction is formed between the $n^+$ region 200a and the p- region 201a. The side surfaces of the first thermoelectric converter 23 are surrounded by an insulating film 222. The p-region 201a has a lower p-type impurity concentration than the $p^+$ region 202a.

The first cell portion 20 also includes a silicide block film 204a, pixel wiring lines 22a, 22b, and silicide films $203a_1$, $203a_2$. The silicide block film 204a prevents short-circuit at the pn junction. The silicide films $203a_1$ and $203a_2$ are formed in the $n^+$ region 200a and the $p^+$ region 202a, respectively, and connect the pixel wiring lines 22a, 22b to the first thermoelectric converter 23 with low resistances. The following expression preferably holds:

$$n \cdot L = \lambda/4 \qquad (1)$$

where L denotes the distance between the conductive layer 205 and the pixel wiring lines 22a, 22b and the distance between the conductive layer 205 and the silicide film $203a_1$, $203a_2$, n denotes the refractive index between the conductive layer 205 and the pixel wiring line 22a or 22b or silicide film $203a_1$, $203a_2$, and A denotes a detected wavelength.

As will be described later, the first cell portion 20 is designed to absorb mid-infrared rays ($2\mu m$ to $6\mu m$) by causing resonance due to interference between the conductive layer 205 and the pixel wiring line 22a or 22b or the silicide film $203a_1$, $203a_2$. Therefore, from the expression (1), the distance L is preferably set in a range of $0.7\mu m$ to $2.2 \mu m$.

The pixel wiring line 22a extends to the corresponding first wiring portion 26, as shown in Fig. 1. Similarly, the pixel wiring line 22b extends to the corresponding second wiring portion 27, as shown in Figs. 1 and 2B.

Like the first cell portion 20, the second cell portion 30 is supported by the second supporting legs 31a, 31b above a recess 210 formed in the support substrate 220 of the SOI substrate (Figs. 1, 3A, and 3B). Thus, the support substrate has a recess 210 below each of the first and the second cell portions 20, 30.

The second cell portion 30 includes a second infrared ray absorbing portion 29 for absorbing infrared rays from the outside, and the second thermoelectric converter 33 for converting heat generated by the infrared ray absorption to electrical signals. The second infrared ray absorbing portion 29 includes a first infrared ray absorbing layer 224b and a second infrared ray absorbing layer 223b.

The second thermoelectric converter 33 is formed in the SOI layer of the SOI substrate, and includes an $n^+$ region 200b, a p- region 201b, and a $p^+$ region 202b to form a pn junction diode. The pn junction is formed between the $n^+$ region 200b and the p- region 201b. The side surfaces of the second thermoelectric converter 33 are surrounded by the insulating film 222.

The second cell portion 30 also includes a silicide block film 204b, pixel wiring lines 32a, 32b, and silicide films $203b_1$, $203b_2$. The silicide block film 204b prevents short-circuit at the pn junction. The silicide films $203b_1$ and $203b_2$ are formed in the $n^+$ region 200b and the $p^+$ region 202b, respectively, and connect the pixel wiring lines 32a, 32b and the second thermoelectric converter 33 with low resistances. The pixel wiring line 32a extends to the corresponding first wiring portions 26, as shown in Fig. 1. Similarly, the pixel wiring line 32b extends to the corresponding second wiring portion 27 as shown in Figs. 1 and 3B.

The first wiring portion 26 corresponding to the first cell portion 20 includes an infrared ray absorption film 223 covering the pixel wiring line 22a formed on the insulating film 222, a via 262 formed through the infrared ray absorption film 223, a wiring layer 264 formed on the infrared ray absorption film 223 to connect to the via 262, an infrared ray absorbing layer 224 covering the wiring layer 264, and an insulating film 225 formed on the infrared ray absorbing layer 224, as shown in Fig. 2B. The wiring layer 264 includes a barrier metal layer 266 and a metal wiring line 268 covered by the barrier metal layer 266. The second wiring portion 27 corresponding to the first cell portion 20 has the same structure as the first wiring portion 26 although it is not shown in the cross-sectional view of Fig. 2A.

The first wiring portion 26 corresponding to the second cell portion 30 includes an infrared ray absorption film 223 covering the pixel wiring line 32a formed on the insulating film 222, a via 262 formed through the infrared ray absorption film 223, a wiring layer 264 formed on the infrared ray absorption film 223 to connect to the via 262, an infrared ray absorption film 224 covering the wiring layer 264, and an insulating film 225 formed on the infrared ray absorption film 224, as shown in Fig. 3B. The wiring layer 264 includes a barrier metal layer 266 and a metal wiring line 268 covered by the barrier metal layer 266. The second wiring portion 27 corresponding to the second cell portion 30 has the same structure as the first wiring portion 26 although it is not shown in the cross-sectional view of Fig. 3A.

(Function)

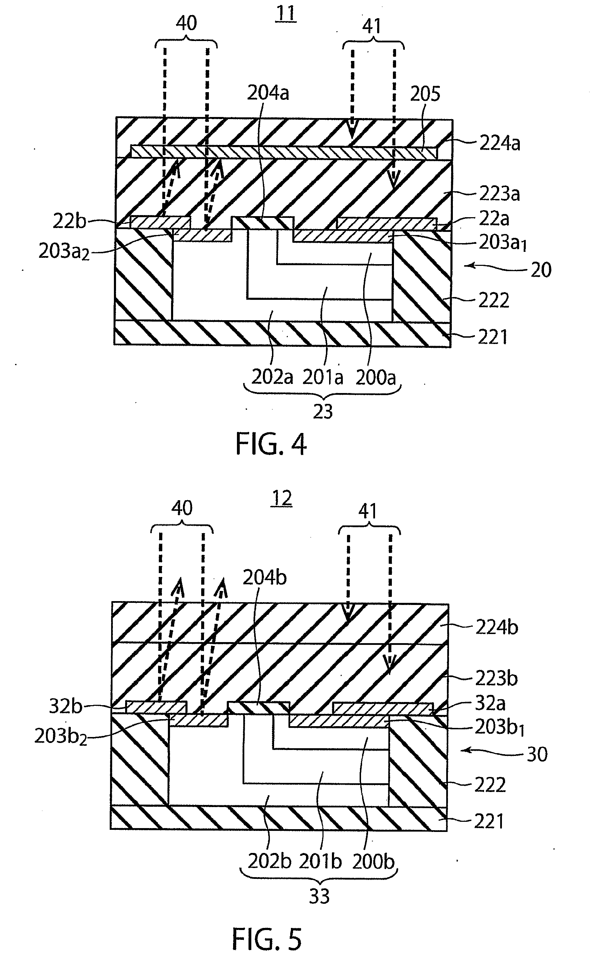

The function of the infrared imaging element according to the first embodiment will be described with reference to Figs. 4 and 5. Fig. 4 is a cross-sectional view of the first cell portion 20 of the first pixel portion 11 for explaining the function thereof. Paths are shown in Fig. 4 of mid-infrared rays 40 (having a wavelength of $2\mu m$ to $6\mu m$) and far-infrared rays 41 (having a wavelength longer than $7\mu m$), among electromagnetic waves incident through an optical system located outside the infrared imaging element.

The mid-infrared rays 40 pass through the protective film 224a of oxide or nitride and reach the conductive layer 205. The conductive layer 205 is a semitransparent film. Part of the mid-infrared rays 40 is absorbed in or reflected on the conductive layer 205, and part thereof passes the conductive layer 205 to move in the depth direction of the first cell portion 20. The mid-infrared rays 40 also pass through the infrared ray absorbing layer 223a of oxide or nitride, and reach the pixel wiring line 22b or the silicide film $203a_2$. The pixel wiring line 22b and the silicide film $203a_2$ act as reflection films. The mid-infrared rays 40 therefore are reflected on the pixel wiring line 22b or the silicide film $203a_2$, pass through the infrared ray absorbing layer 223a again, and reach the conductive layer 205. Part of the mid-infrared rays 40 reaching the conductive layer 205 is reflected there. As described above, the optical distance between the conductive layer 205 and the pixel wiring line 22b or the silicide film $203a_2$ is designed to meet the expression (1). As a result, resonance is produced between the mid-infrared rays reflected on the silicide film $203a_2$ and move toward the conductive layer 205 and the mid-infrared rays incident from the outside of the first cell portion 20 to pass through the conductive layer 205 or reflected on the conductive layer 205 to move toward the silicide film $203a_2$ again. The mid-infrared rays thus are absorbed between the conductive layer 205 and the silicide film $203a_2$. The same occurs when the mid-infrared rays reaches the pixel wiring line 22a or the silicide film $203a_1$.

On the other hand, the far-infrared rays 41 are absorbed by the oxide film or nitride film in the first cell portion 20. Therefore, the incident far-infrared rays 41 are absorbed by the infrared ray absorbing layer 224a or the infrared ray absorbing layer 223a. Thus, both the mid-infrared rays 40 and the far-infrared rays 41 are absorbed and converted to thermal energy in the first cell portion 20. The converted thermal energy is converted to electrical signals in the thermoelectric converter 23, and conveyed to the outside via the wiring lines 22a, 22b.

Next, the function of the second pixel portion 12 will be described with reference to Fig. 5. The mid-infrared rays 40 of the electromagnetic waves incident on the second pixel portion 12 pass through the infrared ray absorbing layer 224b and the infrared ray absorbing layer 223b to reach the pixel wiring line 32b or the silicide film $203b_2$. Since the pixel wiring line 32b and the silicide film $203b_2$ act as reflection films as described above, the mid-infrared rays 40 are reflected on the pixel wiring line 32b or the silicide film $203b_2$. Thereafter, the mid-infrared rays 40 pass through the infrared ray absorption film 223b the infrared ray absorption film 224b again to move outside the second cell portion 30. Thus, the mid-infrared rays incident on the second cell portion 30 are not absorbed in the second cell portion 30. The same occurs when the mid-infrared rays reach the pixel wiring line 32a or the silicide film $203b_1$.

The far-infrared rays 41 are absorbed by the infrared ray absorption film 224b or the infrared ray absorption film 223b to be converted into thermal energy. The converted thermal energy is converted to electrical signals at the thermoelectric converter 33, and conveyed to the outside of the second cell portion 30 via the pixel wiring lines 32a, 32b.

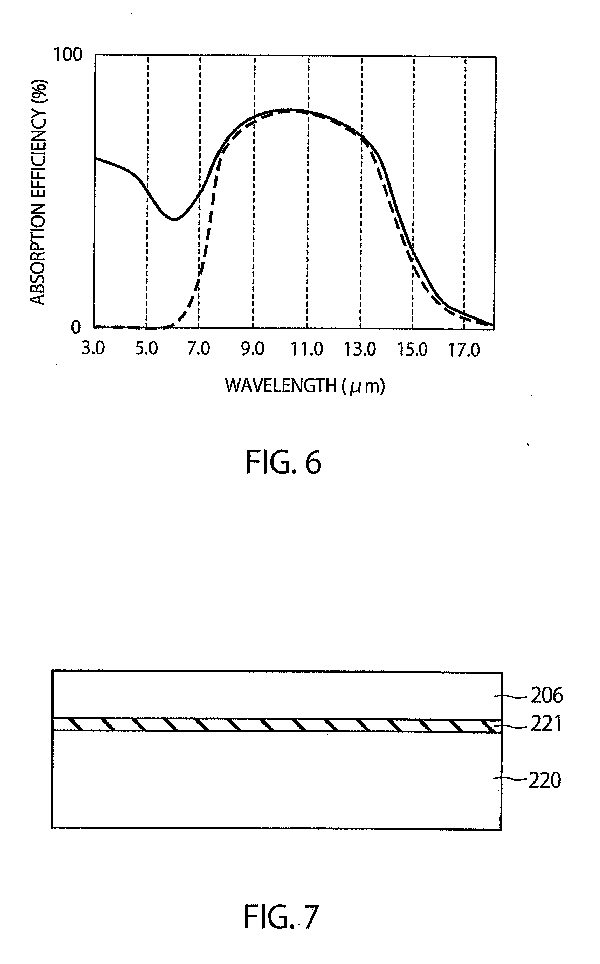

As described above, both the mid-infrared rays 40 and the far-infrared rays 41 of the incident electromagnetic waves are absorbed in the first cell portion 20 of the first pixel portion 11 and converted to electrical signals. In contrast, in the second pixel portion 12, the far-infrared rays 41 of the incident electromagnetic waves are absorbed in the second cell portion 30, and converted into electrical signals. As a result, first information (indicated by the solid line shown in Fig. 6) can be acquired by the absorption of the mid-infrared rays and the far-infrared rays in first pixel portion 11, and second information (indicated by the broken line in Fig. 6) can be acquired by the absorption of the far-infrared rays in the second pixel portion 12. The information obtained is processed, specifically by subtracting the second information from the first information, to obtain information relating to the absorption of the mid-infrared rays. Thus, according to the first embodiment, the information based on the mid-infrared rays and the information based on the far-infrared rays can be simultaneously obtained.

(Manufacturing Method)

A method of manufacturing the infrared imaging element 10 according to the first embodiment will be described with reference to cross-sectional views shown in Figs. 7 to 17.

First, as shown in Fig. 7, an insulating film 221 is formed on a support substrate 220, and a semiconductor layer 206 is formed on the insulating film 221. The support substrate 220 is, for example, a single crystal silicon substrate. The insulating film 221 is, for example, an embedded silicon oxide film. The semiconductor layer 206 is, for example, a monocrystalline silicon layer. The SOI substrate is formed in this manner.

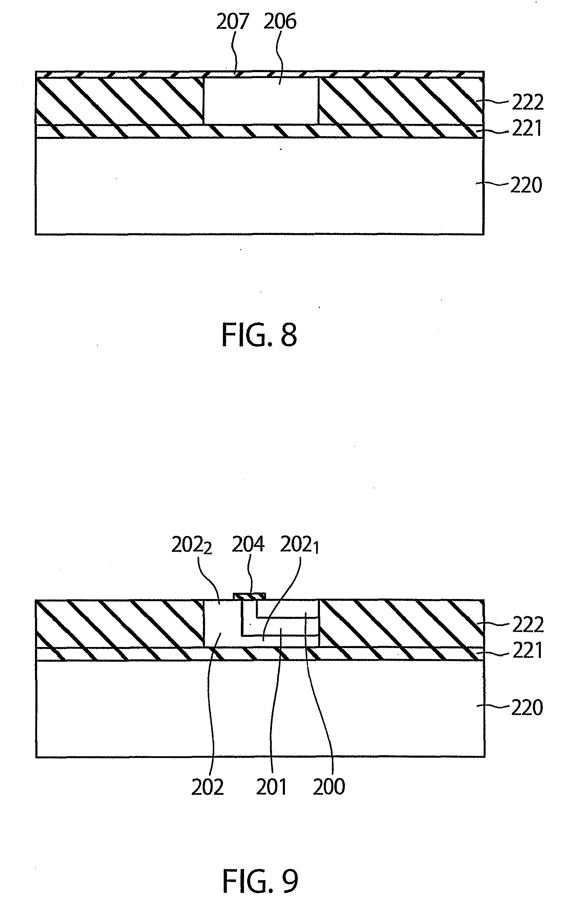

Next, as shown in Fig. 8, the semiconductor layer 206 is removed by a photolithographic technique and an etching technique except for regions on which thermoelectric converters 23, 33 are to be formed, and an element isolation insulating film 222 is embedded in the regions from where the semiconductor layer 206 is removed. The etching is, for example, reactive ion etching (RIE). The element isolation insulating film 222 is, for example, a silicon oxide film. The element isolation insulating film 222 may be formed by embedding a silicon oxide film into the spaces left after the semiconductor layer 206 is removed by chemical vapor deposition (CVD), and planarizing the silicon oxide film by chemical mechanical polishing (CMP). The silicon oxide film used as the element isolation insulating film 222 is also used as an element isolation insulating film for separating the inside and the outside of infrared ray imaging region, and an element isolation insulating film for separating pixels (infrared ray detecting elements). Subsequently, an insulating layer 207 is formed on the surface of the semiconductor layer 206. The insulating layer 207 may be formed by oxidizing the surface of the semiconductor layer 206, or forming another silicon oxide film onto the semiconductor layer 206 and the element isolation insulating film 222.

Then, as shown in Fig. 9, pn junction diodes to serve as the thermoelectric converters 23, 33 are formed. For example, a $p^+$ region 202, a p- region 201, and an $n^+$ region 200 are formed in the semiconductor layer 206 by a photolithographic technique and ion implantation. Specifically, a region is defined by a photolithographic technique in which the $n^+$ region 200 is to be formed, and ion implantation is performed therein to form the $n^+$ region 200. Subsequently, a $p^+$ bottom region $202_1$ to serve as a part of the $p^+$ region 202 is formed in a deeper region of the semiconductor layer 206, and a $p^+$ contact region $202_2$ to serve as another part of the $p^+$ region 202 is formed in a shallower portion (surface) of the semiconductor layer 206. The $p^+$ contact region $202_2$ is separated from the $n^+$ region 200 in the shallower region (surface) of the semiconductor layer 206. A $p^+$ region 202 connecting the $p^+$ contact region $202_2$ and the $p^+$ bottom region $202_1$ is formed therebetween. A p- region 201 is formed between the $p^+$ region 202 and the $n^+$ region 200. Thereafter, the insulating layer 207 is removed from all the regions.

Subsequently, a block film 204 is formed on the surface of the semiconductor layer 206 to cover an end of the $p^+$ region 202 on the side of the $n^+$ region 200 to an end of the $n^+$ region 200 on the side of the $p^+$ region 202 (Fig. 9). The block film 204 is, for example, a silicon oxide film. The block film 204 may be formed by forming a silicon oxide film on the entire surface of the workpiece including the surface of the semiconductor layer 206 by CVD, and patterning the silicon oxide film by photolithography and RIE. In some cases, the insulating layer 207 may be left and processed to have a predetermined shape to serve as the block film 204. The block film 204 has a function to isolate the $n^+$ region 200 from the p-region 201 and the $p^+$ region 202 in a silicidation step which will be described later.

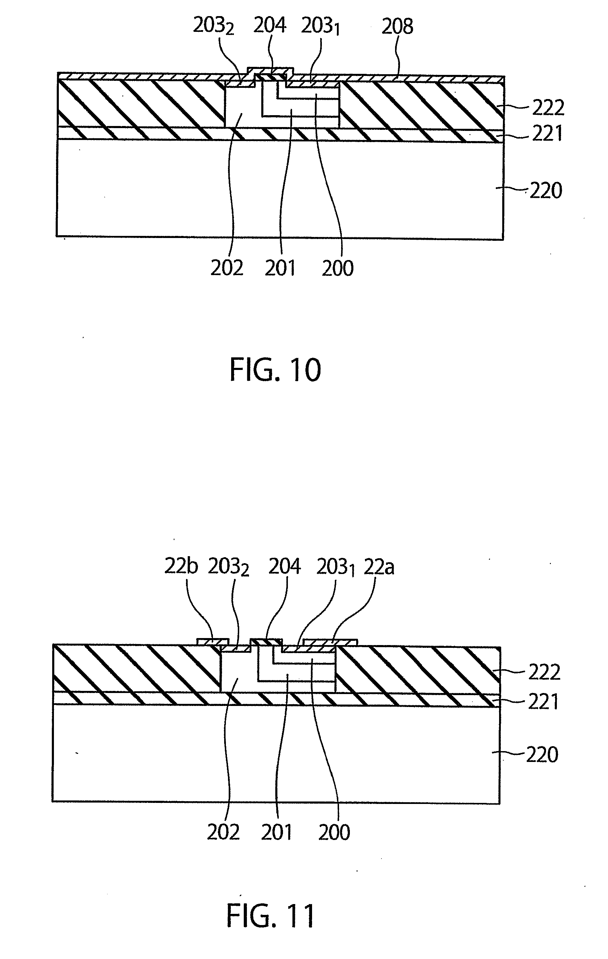

Next, a metal film 208 to serve as pixel wiring lines 21 is formed by, for example, a sputtering method as shown in Fig. 10. A Ti film may be used as the metal film 208. The thickness of the metal film 208 is, for example, 50 nm. Thereafter, the silicide film $203_1$ is formed in the $n^+$ region 200 on the side of the metal film 208, and a silicide film $203_2$ is formed in the $p^+$ region 202 on the side of the metal film 208 by annealing the workpiece at a temperature of 650°C in a nitrogen atmosphere. In this example, the silicide film $203_1$ and the silicide film $203_2$ are TiSi films. Since the region between the $n^+$ region 200 and the $p^+$ region 202 on the surface of the semiconductor layer 206 is covered by the block film 204, no silicide film is formed in this region. Therefore, the $n^+$ region 200 and the p- region 201 or $p^+$ region are not electrically connected with each other. Besides Ti, a metal capable of forming a silicide such as Co and Ni can be arbitrarily selected to form the metal film 208.

In this manufacturing method, silicide films, the silicide film $203_1$ and the silicide film $203_2$, are formed in the first cell portion 20 and the second cell portion 30, respectively on the metal film 208 on the side of the substrate 220. This enables a low resistance connection between the metal film 208 and the thermoelectric converters 23, 33.

Next, as shown in Fig. 11, pixel wiring lines 22a, 22b are formed by removing unnecessary portions from the metal film 208. Since Fig. 11 shows the first pixel portion 11, pixel wiring line 32a, 32b of the second pixel portion 12 are not shown therein. However, at the same time as the pixel wiring lines 22a, 22b are formed, the pixel wiring lines 32a, 32b are also formed. The specific method of forming the pixel wiring lines is as follows. First, portions of the metal film 208 to serve as the pixel wiring lines are covered by resist layers (not shown). Subsequently, the metal film 208 is etched using the resist layers as masks to remove the portions of the metal film 208 not covered by the resist layers. The etching may be wet etching with a mixed solution containing ammonia and hydrogen peroxide. Thereafter, the resist layers are removed. The pixel wiring lines are formed in this manner.

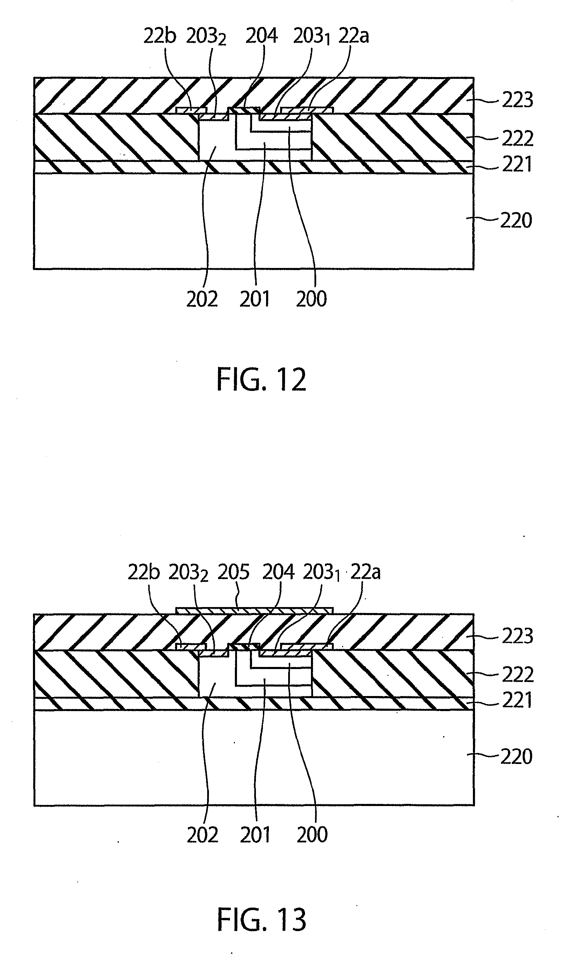

Next, a silicon oxide film 223 to serve as infrared ray absorbing layers 223a, 223b is formed by CVD, as shown in Fig. 12.

Subsequently, a conductive film 205 is formed at the position where the first cell portion 20 is to be formed in the first pixel portion 11 by, for example, a sputtering method, as shown in Fig. 13. The conductive film 205 may be formed of, for example, Ti, Ni, and Co. The thickness of the conductive film 205 is preferably 5 nm or less, and may be a few tens nm or less. No conductive film 205 is formed at a position where the second cell portion of the second pixel portion 12 is to be formed.

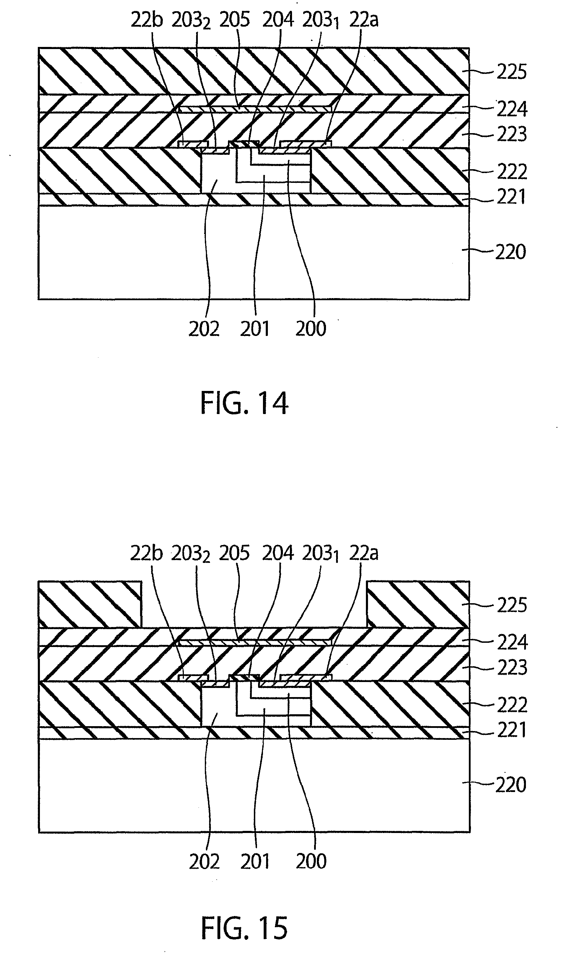

Next, as shown in Fig. 14, the infrared ray absorption film 224 is formed on the conductive layer 205, and the insulating film 225 is formed thereon. Then, the insulating film 225 is removed from regions other than wiring regions by means of a photolithographic technique and etching (Fig. 15).

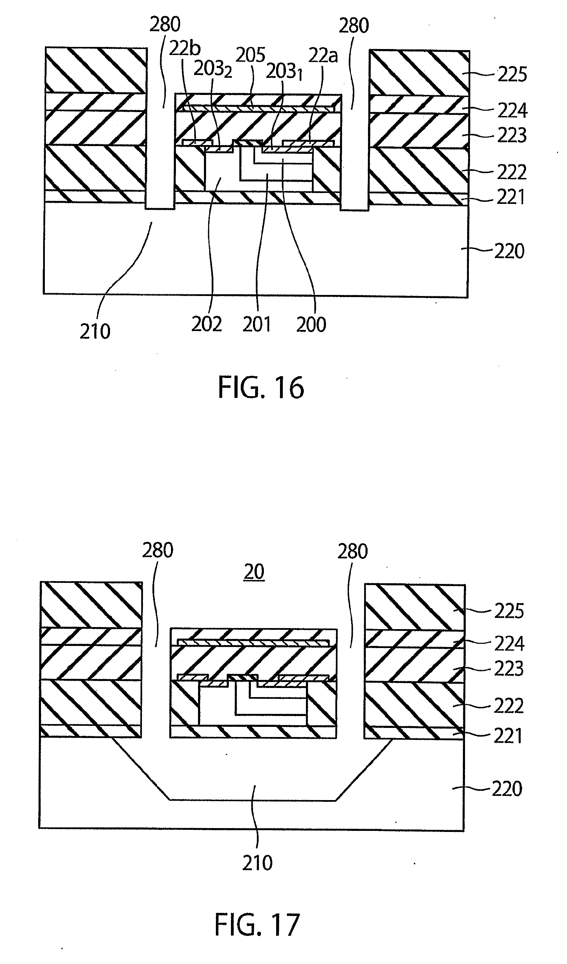

Subsequently, some portions of the insulating film 221, the element isolation insulating film 222, the infrared ray absorption film 223, and the infrared ray absorption film 224 are removed to form etching holes 280 so that the first and the second cell portions 20, 30 are separated from the wiring regions (Fig. 16). The support substrate 220 is exposed on the bottom of each etching hole 280. This processing is performed by a photolithographic technique and etching so that first supporting legs 21a, 21b and second supporting legs 31a, 31b are left, as shown in the plan view in Fig. 1.

Thereafter, the surface of the support substrate 220 is etched through the etching hole 280 to form recesses 210 between the first cell portion 20 and the support substrate 220, and between the second cell portion 30 and the support substrate 220, as shown in Fig. 17. An anisotropy wet etching material such as tetra-methyl-ammonium-hydroxide (TMAH) can be used in this etching. Through the aforementioned process, an infrared imaging element 10 is formed.

In the above descriptions, the process of forming the wiring layer 264 and the via 262 of the first wiring portions 26 shown in Figs. 2B and 3B is omitted.

As described above, according to the first embodiment, an infrared imaging element can be provided which is capable of detecting a plurality of wavelength bands simultaneously without switching optical lenses. The infrared imaging element according to the first embodiment detects infrared rays by thermoelectric conversion, and therefore does not need any cooling mechanism. Since no cooling mechanism is needed and no switching of optical lenses is required in the first embodiment, downsizing and low costs can be achieved.

(Second Embodiment)

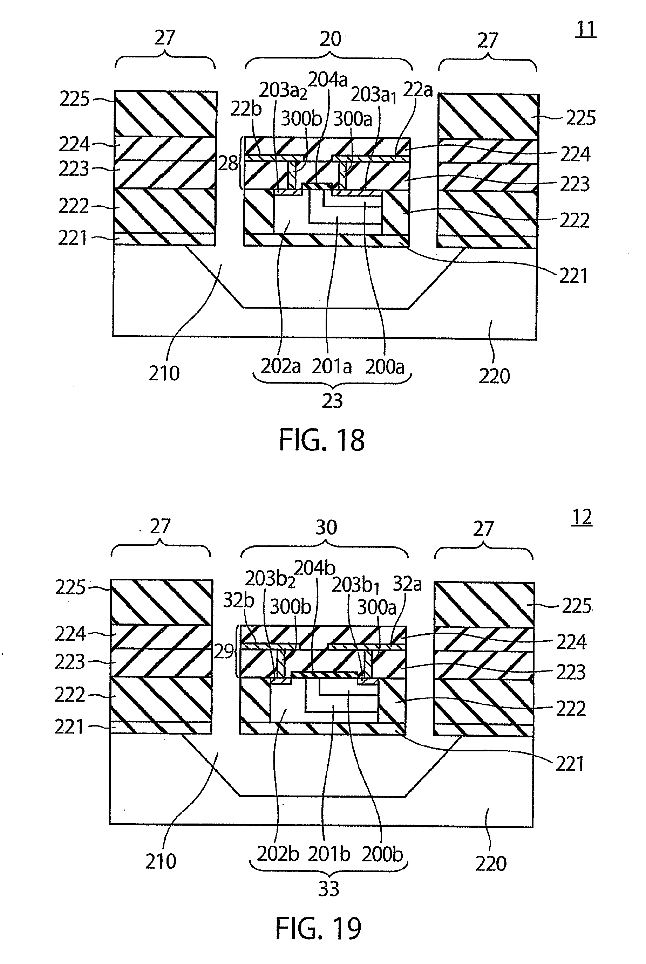

An infrared imaging element according to a second embodiment will be described with reference to Figs. 18 and 19. Fig. 18 is a cross-sectional view showing a first pixel portion 11 for absorbing mid-infrared rays and far-infrared rays of the infrared imaging element according to the second embodiment, and Fig. 19 is a cross-sectional view showing a second pixel portion 12 for absorbing far-infrared rays of the infrared imaging element according to the second embodiment.

Although the wiring layers 22a, 22b of the infrared imaging element according to the first embodiment shown in Figs. 2A and 2B are disposed on the silicide films $203a_1$, $203a_2$, wiring layers 22a, 22b of the first pixel portion of the second embodiment shown in Fig. 18 are disposed on an infrared ray absorbing layer 223. Furthermore, the infrared imaging element according to the second embodiment does not include a conductive layer 205. In Figs. 18 and 19, the wiring layer 264 and the via 262 shown in Figs. 2B and 3B are not shown.

In the first pixel portion 11 according to the second embodiment, a silicide film $203a_1$ on a pn junction diode is electrically connected to the wiring layer 22a through a contact layer 300a, and a silicide film $203a_2$ is electrically connected to the wiring layer 22b with a contact layer 300b.

Mid-infrared rays from the outside pass through the infrared ray absorbing layer 224, a part of the mid-infrared rays being reflected on the wiring layers 22a, 22b, and the rest thereof passing through the wiring layers 22a, 22b, moving toward the infrared ray absorbing layer 223, and being reflected by the silicide films $203a_1$, $203a_2$. The reflected mid-infrared rays pass through the infrared ray absorbing layer 223, reach the wiring layers 22a, 22b, and are reflected by the wiring layers 22a, 22b. As a result, as in the case of the first embodiment, resonance occurs between the mid-infrared rays passing through the wiring layers 22a, 22b and the mid-infrared rays reflected by the silicide films $203a_1$, $203a_2$ in locations between the silicide film $203a_1$ and the wiring layer 22a and between the silicide film $203a_2$ and the wiring layer 22b. The mid-infrared rays are then absorbed by the infrared ray absorbing layer 223. As described in the descriptions of the first embodiment, the optical distance between the silicide film $203a_1$ and the wiring layer 22a, and between the silicide film $203a_2$ and the wiring layer 22b is set to meet the expression (1). The far-infrared rays are absorbed by the infrared ray absorbing layer 223 and the infrared ray absorbing layer 224.

Although the basic structure of the second pixel portion 12 of the second embodiment shown in Fig. 19 is the same as that of the first pixel portion 11 of the second embodiment shown in Fig. 18, the width of the silicide block film 204b (the lateral direction in the diagram) of the first pixel portion 11 is wider, and the width of the silicide film $203b_1$, $203b_2$ (the lateral direction in the diagram) is set to be a minimum that enables the formation of the contact layers 300a, 300b. As a result, the size of the silicide films $203b_1$, $203b_2$ is substantially the same as that of the contact layers 300a, 300b. With such a structure, substantially no region of the silicide films $203b_1$, $203b_2$ faces the wiring layers 32a, 32b disposed on the other side of the infrared ray absorbing layer 223, and therefore the resonance of the mid-infrared rays is unlikely to occur. The far-infrared rays are absorbed by the infrared ray absorbing layers 223 and 224. Thus, the second pixel portion 12 shown in Fig. 19 only responds to far-infrared rays.

The two wavelengths may be detected separately by setting the area in which the silicide layers faces the wiring layers disposed on the other side of the infrared ray absorbing layer 223 to be different between the first pixel portion 11 and the second pixel portion 12.

The infrared imaging element according to the second embodiment is also capable of detect multiple wavelengths simultaneously, like the infrared imaging element according to the first embodiment. Since no cooling mechanism is needed and no switching of optical lenses is required downsizing and low costs can be achieved.

(Modification)

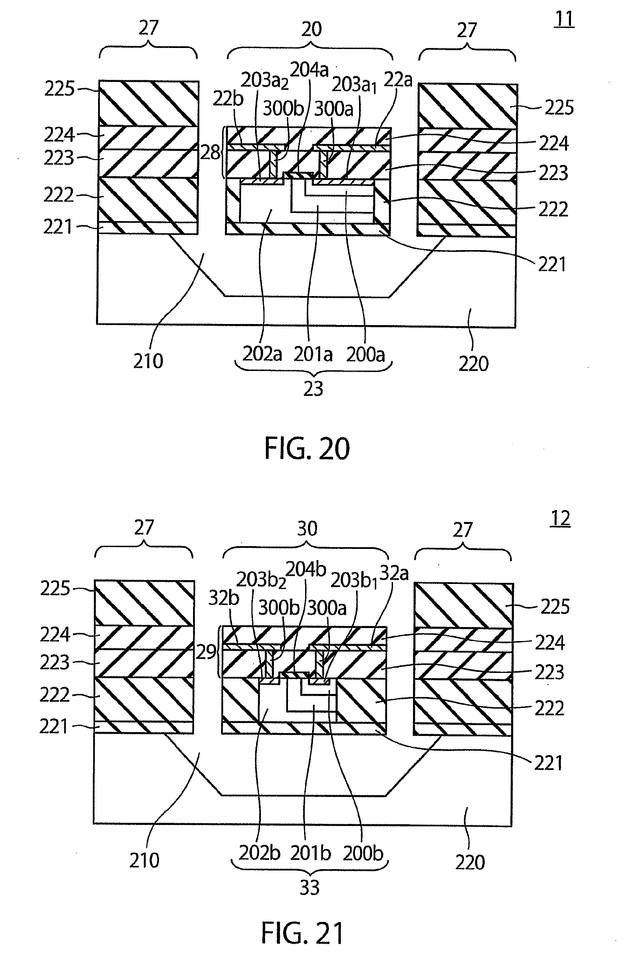

Figs. 20 and 21 shows cross-sections of a first and a second pixel portions 11, 12 of an infrared imaging element according to a modification of the second embodiment. In this modification, widths of the $n^+$ region 200a and the $p^+$ region 202a of the first thermoelectric converter 23 in the first pixel portion 11 (lengths in the lateral direction in the drawing) are wider than widths of the $n^+$ region 200b and the $p^+$ region 202b of the second thermoelectric converter 33 in the second pixel portion 12.

By significantly differentiating the size of the thermoelectric converter 23 from the size of the thermoelectric converter 33 as in the modification, the areas of the silicide films opposing the wiring layers on the opposite side of the infrared ray absorbing layer 223 can be made different between the first pixel portion and the second pixel portion, and the same effect as the second embodiment can be obtained.

(Third Embodiment)

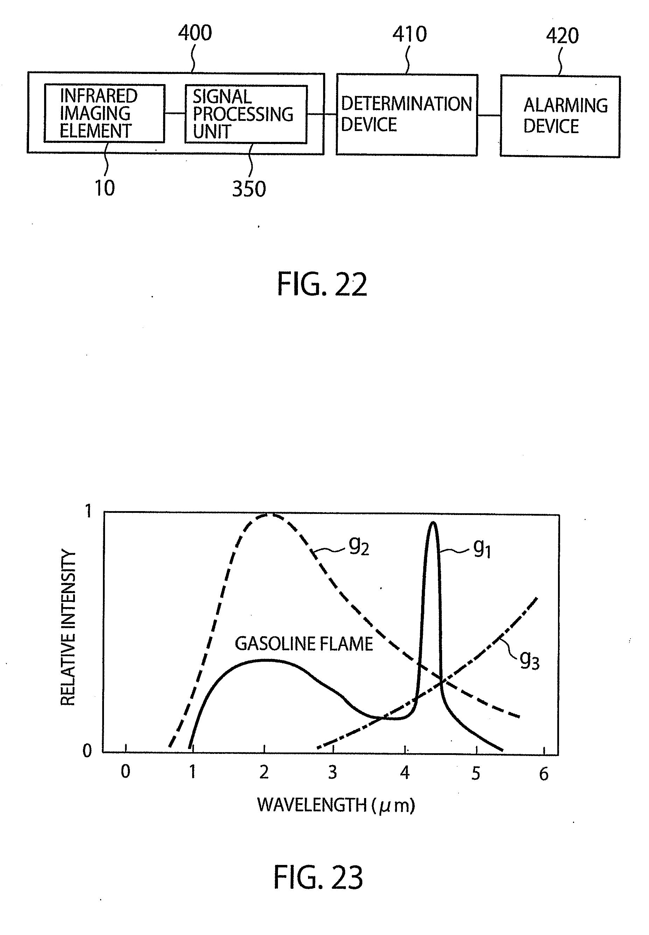

An imaging system according to a third embodiment will be described with reference to Figs. 22 and 23. Fig. 22 is a block diagram of the imaging system according to the third embodiment. The imaging system according to the third embodiment includes an imaging device 400 including the infrared imaging element 10 and a signal processing unit 350 according to any of the first embodiment, the second embodiment, and the modifications thereof, a determination device 410 for determining an object based on signals from the imaging device 400, and an alarming device 420 for giving an alarm based on the determination result of the determination device 410. The signal processing unit 350 processes signals from the infrared imaging element 10 to generate image signals.

The imaging system according to the third embodiment can be used for detecting gasoline flame. The graphs $g_1$, $g_2$, and $g_3$ shown in Fig. 23 indicate the relative intensity spectra of gasoline flame, a high temperature object (for example, 1400 K), and a low temperature object (for example, 350K), respectively. As can be understood from Fig. 23, the gasoline flame spectrum has a spike. Furthermore, the intensity in a mid-infrared range of the gasoline flame spectrum is considerably greater than that of a far-infrared range. The distribution of the intensity of the high-temperature object spectrum extends from the mid-infrared range to the far-infrared range. Therefore, it may be possible to detect gasoline frame by a known mid-infrared sensor but it would be difficult to distinguish gasoline frame from a high temperature object if the total intensity is equal.

The infrared imaging element 10 of the imaging device 400 according to the third embodiment allows a mid-infrared image and a far-infrared image to be captured simultaneously. Images captured by the infrared imaging element 10 are processed by the signal processing unit 350 where image signals are created. Subsequently, the determination device 410 calculates a ratio between pixel values of the mid-infrared image and the far-infrared image based on the image signals obtained from the imaging device 400. As a result, characteristics of the object can be determined based on the ratio in pixel value between the mid-infrared image and the far-infrared image. The determination device 410 prestores material data corresponding to the ratio. If the captured image is determined to be gasoline flare, an alarm command signal is sent to the alarming device 420. Upon receiving the alarm command signal, the alarming device 420 provides an alarm to notify the user of the abnormal condition.

As in the case of the first embodiment, the imaging system according to the third embodiment is capable of detecting multiple wavelengths simultaneously. Furthermore, since no cooling mechanism is needed, and no switching of optical lenses is required, downsizing and low costs can be achieved.

Thus, the target material can be detected by capturing images in two wavelengths simultaneously, and performing calculation using the obtained data. The optical system of the imaging device 400 is preferably formed of a material transmitting lights in the mid-infrared range and the far-infrared range. A preferable system is basically formed of germanium or chalcogenide glass with an antireflection film formed thereon, the antireflection film being designed to transmit lights having a long wavelength in the mid-infrared range or more.

While certain embodiments have been described, these embodiments have been presented by way of example only, and are not intended to limit the scope of the inventions. Indeed, the novel methods and systems described herein may be embodied in a variety of other forms; furthermore, various omissions, substitutions and changes in the form of the methods and systems described herein may be made without departing from the spirit of the inventions. The accompanying claims and their equivalents are intended to cover such forms or modifications as would fall within the scope and spirit of the inventions.

**Claims**

1. An infrared imaging element comprising:

   a substrate having a surface in which a first recess and a second recess are provided;
   a first pixel portion including;
   a first cell portion disposed above the first recess and including a first infrared ray detecting portion that detects a first infrared ray with a wavelength incident from outside and a second infrared ray with a wavelength different from the wavelength of the first infrared ray and converts the first and the second infrared rays to electrical signals, first supporting legs that support the first cell portion to be above the first recess, the first supporting legs including a first wiring line and a second wiring line that convey the electrical signals obtained by the first infrared ray detecting portion; and
   a second pixel portion including a second cell portion disposed above the second recess and a second infrared ray detecting portion that detects the second infrared ray and converts the detected second infrared ray to an electrical signal, and second supporting legs that support the second cell portion to be above the second recess, the second supporting legs including a third wiring line and a fourth wiring line that convey the electrical signal obtained by the second infrared ray detecting portion.

2. The element according to claim 1, wherein the first infrared ray detecting portion includes:

   a first infrared ray absorbing layer that absorbs a part of the first infrared ray and the second infrared ray and transmits the rest thereof;
   a second infrared ray absorbing layer disposed below the first infrared ray absorbing layer to absorb a part of the first infrared ray and the second infrared ray and transmits the rest thereof;
   a conductive layer disposed between the first infrared ray absorbing layer and the second infrared ray absorbing layer, the conductive layer transmitting a part of the first infrared ray and absorbing or reflecting the rest of the first infrared ray; and
   a first thermoelectric converter that converts heat generated by the first infrared ray absorbing layer, the second infrared ray absorbing layer, and the conductive layer, and

the second infrared ray detecting portion includes:

a third infrared ray absorbing layer that absorbs a part of the first infrared ray and the second infrared ray, and transmits the rest thereof; and

a fourth infrared ray absorbing layer that is disposed below the third infrared ray absorbing layer and absorbs a part of the first infrared ray and the second infrared ray, and transmits the rest thereof; and

a second thermoelectric converter that converts heat generated by the third infrared ray absorbing layer and the fourth infrared ray absorbing layer to electrical signals.

3. The element according to claim 2, wherein:

each of the first thermoelectric converter and the second thermoelectric converter includes a first semiconductor region of p-type, a second semiconductor region of p-type formed on a part of the first semiconductor region, the second semiconductor region of p-type having a lower p-type impurity concentration than the first semiconductor region of p-type, a third semiconductor region of n-type formed on a part of the second semiconductor region, and a first silicide layer and a second silicide layer formed on the first semiconductor region and the third semiconductor region, respectively;

in the first thermoelectric converter, the first silicide layer, the second silicide layer, and the second semiconductor region are covered by the second infrared ray absorbing layer, an optical distance between the first silicide layer and the conductive layer, and between the second silicide layer and the conductive layer is 1/4 of the wavelength of the first infrared ray, and the first silicide layer and the second silicide layer are connected to the first wiring line and the second wiring line, respectively; and

in the second thermoelectric converter, the first silicide layer, the second silicide layer, and the second semiconductor region are covered by the fourth infrared ray absorbing layer, the first silicide layer and the second silicide layer are connected the third wiring line and the fourth wiring line, respectively.

4. The element according to claim 1, wherein the first infrared ray detecting portion includes:

a first infrared ray absorbing layer that absorbs a part of the first infrared ray and the second infrared ray and transmits the rest thereof;

a second infrared ray absorbing layer that is disposed below the first infrared ray absorbing layer, absorbs a part of the first infrared ray and the second infrared ray, and transmits the rest thereof;

a first thermoelectric converter including a first semiconductor region of p-type, a second semiconductor region of p-type that is disposed on a part of the first semiconductor region and has a lower p-type impurity concentration than the first semiconductor region, a third semiconductor region of n-type that is disposed on a part of the second semiconductor region, and a first silicide layer and a second silicide layer disposed on the first semiconductor region and the third semiconductor region, respectively, the first thermoelectric converter converting heat generated by the first infrared ray absorbing layer and the second infrared ray absorbing layer to electrical signals;

a first pixel wiring line and a second pixel wiring line disposed on the second infrared ray absorbing layer and connected to the first wiring line and the second wiring line, respectively;

a first contact formed in the second infrared ray absorbing layer to connect to the first pixel wiring line and the first silicide layer; and

a second contact formed in the second infrared ray absorbing layer to connect to the second pixel wiring line and the second silicide layer; and

the second infrared ray detecting portion includes:

a third infrared ray absorbing layer that absorbs a part of the first infrared ray and the second infrared ray, and transmits the rest thereof;

a fourth infrared ray absorbing layer that is disposed below the third infrared ray absorbing layer, absorbs a part of the first and second infrared ray, and transmits the rest thereof;

a second thermoelectric converter including a fourth semiconductor region of p-type, a fifth semiconductor region of p-type disposed on a part of the fourth semiconductor region and having a lower p-type impurity concentration than the fourth semiconductor region, a sixth semiconductor region of n-type disposed on a part of the fifth semiconductor region, and a third silicide layer and a fourth silicide layer disposed on the fourth semiconductor region and the sixth semiconductor region, respectively, the second thermoelectric converter converting heat generated by the third infrared ray absorbing layer and the fourth infrared ray absorbing layer into electrical signals;

a third pixel wiring line and a fourth pixel wiring line disposed on the fourth infrared ray absorbing layer and connecting to the third wiring line and the fourth wiring line, respectively;

a third contact connecting to the third pixel wiring line and the third silicide layer; and a fourth contact connecting to the fourth pixel wiring line and the fourth silicide layer, widths of the third silicide layer and the fourth silicide layer being narrower than widths of the first silicide layer and the second silicide layer, respectively, and substantially the same as widths of the third contact and the fourth contact.

5. The element according to claim 1, wherein:

the first infrared ray detecting portion includes:

a first infrared ray absorbing layer that absorbs a part of the first infrared ray and the second infrared ray, and transmits the rest thereof;

a second infrared ray absorbing layer that is disposed below the first infrared ray absorbing layer, absorbs a part of the first infrared ray and the second infrared ray, and transmits the rest thereof;

a first thermoelectric converter including a first semiconductor region of p-type, a second semiconductor region of p-type disposed on a part of the first semiconductor region, and having a lower p-type impurity concentration than the first semiconductor region, a third semiconductor region of n-type disposed on a part of the second semiconductor region, and a first silicide layer and a second silicide layer disposed on the first semiconductor region and the third semiconductor region, respectively, the first thermoelectric converter converting heat generated by the first infrared ray absorbing layer and the second infrared ray absorbing layer into electrical signals;

a first pixel wiring line and a second pixel wiring line disposed on the second infrared ray absorbing layer and connecting to the first wiring line and the second wiring line, respectively;

a first contact connecting to the first pixel wiring line and the first silicide layer;

a second contact connecting to the second pixel wiring line and the second silicide layer,

and

the second infrared ray detecting portion includes:

a third infrared ray absorbing layer that absorbs a part of the first infrared ray and the second infrared ray, and transmits the rest thereof;

a fourth infrared ray absorbing layer that is disposed below the third infrared ray absorbing layer, absorbs a part of the first infrared ray and the second infrared ray, and transmits the rest thereof;

a second thermoelectric converter including a fourth semiconductor region of p-type, a fifth semiconductor region of p-type that is disposed on a part of the fourth semiconductor region and has a lower p-type impurity concentration than the fourth semiconductor region, a sixth semiconductor region of n-type that is disposed on a part of the fifth semiconductor region, and a third silicide layer and a fourth silicide layer disposed on the fourth semiconductor region and the sixth semiconductor region, respectively, the second thermoelectric converter converting heat generated by the third infrared ray absorbing layer and the fourth infrared ray absorbing layer into electrical signals;

a third pixel wiring line and a fourth pixel wiring line disposed on the fourth infrared ray absorbing layer to connect the third wiring line and the fourth wiring line, respectively;

a third contact connecting to the third pixel wiring line and the third silicide layer; and a fourth contact connecting to the fourth pixel wiring line and the fourth silicide layer, a width of the second thermoelectric converter being narrower than a width of the first thermoelectric converter and widths of the third silicide layer and the fourth silicide layer being narrower than widths of the first silicide layer and the second silicide layer, respectively.

6. The element according to claim 3, wherein a silicide block film is disposed on the second semiconductor region.

7. The element according to claim 1, comprising a plurality of first recesses and a plurality of second recesses, wherein the first recesses and the second recesses are alternately arranged in rows and columns on a surface of the substrate, the first pixel portion being disposed above each of the first recesses, and the second pixel portion being disposed above each of the second recesses.

8. The element according to claim 7, further comprising:

first wiring portions each corresponding to one of the rows and disposed between adjacent rows on the substrate, the first wiring line of the first pixel portion and the third wiring line of the second pixel portion being connected to one of the first wiring portions; and
second wiring portions each corresponding to one of the columns and disposed between adjacent columns on the substrate, the second wiring of the first pixel portion and the fourth wiring of the second pixel portion being connected to one of the second wiring portions.

9. The element according to claim 1, wherein the first infrared ray is a mid-infrared ray, and the second infrared ray is a far-infrared ray.

10. An imaging device comprising:

the infrared imaging element according to claim 1; and
a signal processing unit that processes signals obtained from an image captured by the infrared imaging element.

11. The device according to claim 10, wherein the first infrared ray detecting portion includes:

a first infrared ray absorbing layer that absorbs a part of the first infrared ray and the second infrared ray and transmits the rest thereof;
a second infrared ray absorbing layer disposed below the first infrared ray absorbing layer to absorb a part of the first infrared ray and the second infrared ray and transmits the rest thereof;
a conductive layer disposed between the first infrared ray absorbing layer and the second infrared ray absorbing layer, the conductive layer transmitting a part of the first infrared ray and absorbing or reflecting the rest of the first infrared ray; and
a first thermoelectric converter that converts heat generated by the first infrared ray absorbing layer, the second infrared ray absorbing layer, and the conductive layer, and
the second infrared ray detecting portion includes:

a third infrared ray absorbing layer that absorbs a part of the first infrared ray and the second infrared ray, and transmits the rest thereof; and
a fourth infrared ray absorbing layer that is disposed below the third infrared ray absorbing layer and absorbs a part of the first infrared ray and the second infrared ray, and transmits the rest thereof; and
a second thermoelectric converter that converts heat generated by the third infrared ray absorbing layer and the fourth infrared ray absorbing layer to electrical signals.

12. The device according to claim 11, wherein:

each of the first thermoelectric converter and the second thermoelectric converter includes a first semiconductor region of p-type, a second semiconductor region of p-type formed on a part of the first semiconductor region, the second semiconductor region of p-type having a lower p-type impurity concentration than the first semiconductor region of p-type, a third semiconductor region of n-type formed on a part of the second semiconductor region, and a first silicide layer and a second silicide layer formed on the first semiconductor region and the third semiconductor region, respectively;
in the first thermoelectric converter, the first silicide layer, the second silicide layer, and the second semiconductor region are covered by the second infrared ray absorbing layer, an optical distance between the first silicide layer and the conductive layer, and between the second silicide layer and the conductive layer is 1/4 of the wavelength of the first infrared ray, and the first silicide layer and the second silicide layer are connected to the first wiring line and the second wiring line, respectively; and
in the second thermoelectric converter, the first silicide layer, the second silicide layer, and the second semiconductor region are covered by the fourth infrared ray absorbing layer, the first silicide layer and the second silicide layer are connected the third wiring line and the fourth wiring line, respectively.

13. The device according to claim 10, wherein the first infrared ray detecting portion includes:

a first infrared ray absorbing layer that absorbs a part of the first infrared ray and the second infrared ray and transmits the rest thereof;
a second infrared ray absorbing layer that is disposed below the first infrared ray absorbing layer, absorbs a part of the first infrared ray and the second infrared ray, and transmits the rest thereof;
a first thermoelectric converter including a first semiconductor region of p-type, a second semiconductor region of p-type that is disposed on a part of the first semiconductor region and has a lower p-type impurity concentration than the first semiconductor region, a third semiconductor region of n-type that is disposed on a part of the second semiconductor region, and a first silicide layer and a second silicide layer disposed on the first semiconductor region and the third semiconductor region, respectively, the first thermoelectric converter converting heat generated by the first infrared ray absorbing layer and the second infrared ray absorbing layer to electrical signals;

a first pixel wiring line and a second pixel wiring line disposed on the second infrared ray absorbing layer and connected to the first wiring line and the second wiring line, respectively;

a first contact formed in the second infrared ray absorbing layer to connect to the first pixel wiring line and the first silicide layer; and

a second contact formed in the second infrared ray absorbing layer to connect to the second pixel wiring line and the second silicide layer; and

the second infrared ray detecting portion includes:

a third infrared ray absorbing layer that absorbs a part of the first infrared ray and the second infrared ray, and transmits the rest thereof;

a fourth infrared ray absorbing layer that is disposed below the third infrared ray absorbing layer, absorbs a part of the first and second infrared ray, and transmits the rest thereof;

a second thermoelectric converter including a fourth semiconductor region of p-type, a fifth semiconductor region of p-type disposed on a part of the fourth semiconductor region and having a lower p-type impurity concentration than the fourth semiconductor region, a sixth semiconductor region of n-type disposed on a part of the fifth semiconductor region, and a third silicide layer and a fourth silicide layer disposed on the fourth semiconductor region and the sixth semiconductor region, respectively, the second thermoelectric converter converting heat generated by the third infrared ray absorbing layer and the fourth infrared ray absorbing layer into electrical signals;

a third pixel wiring line and a fourth pixel wiring line disposed on the fourth infrared ray absorbing layer and connecting to the third wiring line and the fourth wiring line, respectively;

a third contact connecting to the third pixel wiring line and the third silicide layer; and

a fourth contact connecting to the fourth pixel wiring line and the fourth silicide layer, widths of the third silicide layer and the fourth silicide layer being narrower than widths of the first silicide layer and the second silicide layer, respectively, and substantially the same as widths of the third contact and the fourth contact.

14. The device according to claim 10, wherein:

the first infrared ray detecting portion includes:

a first infrared ray absorbing layer that absorbs a part of the first infrared ray and the second infrared ray, and transmits the rest thereof;

a second infrared ray absorbing layer that is disposed below the first infrared ray absorbing layer, absorbs a part of the first infrared ray and the second infrared ray, and transmits the rest thereof;

a first thermoelectric converter including a first semiconductor region of p-type, a second semiconductor region of p-type disposed on a part of the first semiconductor region, and having a lower p-type impurity concentration than the first semiconductor region, a third semiconductor region of n-type disposed on a part of the second semiconductor region, and a first silicide layer and a second silicide layer disposed on the first semiconductor region and the third semiconductor region, respectively, the first thermoelectric converter converting heat generated by the first infrared ray absorbing layer and the second infrared ray absorbing layer into electrical signals;

a first pixel wiring line and a second pixel wiring line disposed on the second infrared ray absorbing layer and connecting to the first wiring line and the second wiring line, respectively;

a first contact connecting to the first pixel wiring line and the first silicide layer;

a second contact connecting to the second pixel wiring line and the second silicide layer, and

the second infrared ray detecting portion includes:

a third infrared ray absorbing layer that absorbs a part of the first infrared ray and the second infrared ray, and transmits the rest thereof;

a fourth infrared ray absorbing layer that is disposed below the third infrared ray absorbing layer, absorbs a part of the first infrared ray and the second infrared ray, and transmits the rest thereof;

a second thermoelectric converter including a fourth semiconductor region of p-type, a fifth semiconductor region of p-type that is disposed on a part of the fourth semiconductor region and has a lower p-type impurity concentration than the fourth semiconductor region, a sixth semiconductor region of n-type that is disposed on a part of the fifth semiconductor region, and a third silicide layer and a fourth silicide layer disposed on the fourth semiconductor region and the sixth semiconductor region, respectively, the second thermoelectric converter converting heat generated by the third infrared ray absorbing layer and the fourth infrared ray absorbing layer into electrical signals;

a third pixel wiring line and a fourth pixel wiring line disposed on the fourth infrared ray absorbing layer to connect the third wiring line and the fourth wiring line, respectively;

a third contact connecting to the third pixel wiring line and the third silicide layer; and

a fourth contact connecting to the fourth pixel wiring line and the fourth silicide layer, a width of the second thermoelectric converter being narrower than a width of the first thermoelectric converter and widths of the third silicide layer and the fourth silicide layer being narrower than widths of the first silicide layer and the second silicide layer, respectively.

15. The device according to claim 12, wherein a silicide block film is disposed on the second semiconductor region.

16. The device according to claim 10, comprising a plurality of first recesses and a plurality of second recesses, wherein the first recesses and the second recesses are alternately arranged in rows and columns on a surface of the substrate, the first pixel portion being disposed above each of the first recesses, and the second pixel portion being disposed above each of the second recesses.

17. The device according to claim 16, further comprising:

first wiring portions each corresponding to one of the rows and disposed between adjacent rows on the substrate, the first wiring line of the first pixel portion and the third wiring line of the second pixel portion being connected to one of the first wiring portions; and

second wiring portions each corresponding to one of the columns and disposed between adjacent columns on the substrate, the second wiring of the first pixel portion and the fourth wiring of the second pixel portion being connected to one of the second wiring portions.

18. The device according to claim 10, wherein the first infrared ray is a mid-infrared ray, and the second infrared ray is a far-infrared ray.

19. An imaging system comprising:

the imaging device according to claim 10; a determination device that determines an object based on signals processed at the signal processing unit of the imaging device; and an alarming device that provides an alarm depending on a determination result given by the determination device.

FIG. 1

A-A SECTION

FIG. 2A

A'-A' SECTION

FIG. 2B

FIG. 3A

FIG. 3B

FIG. 4

FIG. 5

FIG. 6

FIG. 7

207  206

222

221

220

**FIG. 8**

202₂  204  202₁

222

221

220

202  201  200

**FIG. 9**

FIG. 10

FIG. 11

FIG. 12

FIG. 13

22b 2032 205 204 2031 22a

225
224
223
222
221

220

202 201 200

FIG. 14

22b 2032 205 204 2031 22a

225

224
223
222
221

220

202 201 200

FIG. 15

FIG. 16

FIG. 17

FIG. 18

FIG. 19

FIG. 20

FIG. 21

FIG. 22

FIG. 23